(19) Europäisches Patentamt
European Patent Office
Office européen des brevets

(11) Numéro de publication: **0 000 673**
**B1**

(12) **FASCICULE DE BREVET EUROPEEN**

(21) Numéro de dépôt: **78400038.2**

(22) Date de dépôt: **28.06.78**

(51) Int. Cl.³: **H 05 K 3/00, G 03 F 7/08**

(54) **Procédé de réalisation de circuits imprimés à trous métallisés à partir de supports isolants en stratifié verre-résine synthétique.**

(30) Priorité: **28.07.77 FR 7723251**

(43) Date de publication de la demande:
**07.02.79 Bulletin 79/3**

(45) Mention de la délivrance du brevet:
**18.02.81 Bulletin 81/7**

(84) Etats Contractants Désignés:
**CH DE GB**

(56) Documents cités:
**US - A - 2 897 409**
**US - A - 3 708 876**

(73) Titulaire: **SOCIETE ANONYME DE TELECOMMUNICATIONS**
**40 avenue de New York**
**F-75116 Paris (FR)**

(72) Inventeur: **Lindebrings, Charles Maurice Philippe**
**57 chemin de l'Ardoise**
**72000 LE MANS (FR)**

(72) Inventeur: **Vaillagou, Pierre**
**3 route de Limours**
**F-78470 St Remy les Chevreuses (FR)**

(72) Inventeur: **Velte, André Jean François**
**1 square Boileau**
**F-78150 Parly 2 le Chesnay (FR)**

(74) Mandataire: **Bloch, Robert**
**39 avenue de Friedland**
**F-75008 Paris (FR)**



Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

Procédé de réalisation de circuits imprimés à trous métallisés à partir de supports isolants en stratifié verre-résine synthétique

La présente invention concerne la réalisation de circuits imprimés double face, munis de trous métallisés, à partir de supports isolants en stratifié verre-résine synthétique, par exemple en stratifié verre-époxy ou verre-polyimide.

Dans le procédé classique de réalisation des circuits imprimés double face, on perce les trous à métalliser dans le support isolant, on effectue un dépôt de métal conducteur par métallisation chimique dans les trous et sur les deux faces, on réalise le câblage par gravure du métal conducteur sur les deux faces après avoir déposé une réserve, puis on positionne les composants électriques dans les trous métallisés et on soude la queue des composants dans les trous respectifs pour assurer les liaisons électriques.

La qualité des joints soudés ainsi formés dans les trous métallisés est essentielle pour la fiabilité du circuit, et ces joints doivent être exempts de bulles et de fissures ou cratères.

Or, avec les supports en stratifié verre-résine, on observe précisément la présence de tels défauts dans un nombre de cas non négligeable. La raison en est la suivante. La paroi d'un tel support présente des zones et résine et des zones de fibres de verre qui se trouvent fortement perturbées lors de perçage des trous. Il se forme alors des cavités le long de la paroi et des micro-décollements des fibres de verre. Des impuretés pénètrent dans ces cavités lors des traitements de surface préalables à la métallisation chimique. Les solutions chimiques en contact avec la paroi pénètrent par capillarité de long des torons de verre et laissent des résidus qui ne sont pas éliminés par les rinçages et qui sont emprisonnés par la métallisation ultérieure.

Lors d'un soudage à cadence élevée, tel qu'un soudage à la vague, ces impuretés résiduelles diffusent vers l'extérieur sous l'action de la température et pertubent la qualité du joint soudé en donnant lieu à la formation de bulles, de fissures ou de cratères.

Il en résulte des risques de discontinuité électrique, de court-circuit ou même de décollement du joint soudé. Une opération supplémentaire de reprise au fer à souder est alors nécessaire pour assurer la fiabilité du joint. Une telle opération doit être exécutée à la main et est donc très coûteuse.

L'invention vise un prodédé du type précité ne présentant pas l'inconvénient signalé.

A cet effet, selon l'invention, immédiatement après le perçage des trous, on enduit le support, dont au moins la surface intérieure des trous, avec une résine photosensible susceptible d'être solubilisée par un rayonnement, on expose le support enduit au dit rayonnement de façon non sélective, on élimine la résine solubilisée par le rayonnement puis on sèche le support.

Lors de l'enduction, de la résine pénètre dans les cavités formées lors du perçage des trous. La résine présente dans ces cavités est alors à l'abri du rayonnement et n'est pas solubilisée. On obtient ainsi un bouchage des cavités qui s'oppose à la pénétration d'impuretés lors des traitements ultérieurs et donc à la formation de résidus entre la matière du support et la couche de métallisation.

Le dessin anexé montre en coupe, à très grande échelle, la structure du support dans les différentes phases du procédé selon l'invention.

La figure 1*a* montre, en coupe partielle schématique, un support en stratifié verre-résine, par exemple en verre-époxy. Le stratifié 1 est pris en sandwich entre deux feuillards de cuivre 2 et 3. La présence de ces feuillards évite d'avoir à réaliser un dépôt de métallisarion de trop forte épaisseur, mais elle n'est pas essentielle dans l'invention.

Le support a été percé d'un trou 10 et ce perçage perturbe la structure du stratifié en créant des cavités ou anfractuosités 11.

La figure 1*b* montre le support après enduction par une couche 12 de résine photosensible à l'état pâteux. Celle-ci recouvre la paroi du trou 10 et pénètre dans les cavités 11.

L'enduction est effectuée par tout moyen approprié, par exemple par immersion, centrifugation ou pulvérisation sous vide.

Cette opération est effectuée de préférence sous vide de manière à chasser l'air des cavités.

La figure 1*c* montre la situation après exposition totale du support à un rayonnement approprié. La résine a été solubilisée par l'énergie lumineuse, sauf dans les zones à l'abri du rayonnement, c'est-à-dire précisément dans les cavités 11. On élimine alors la résine solubilisée et il ne subsiste de la résine que dans les cavités 11. Après un séchage destiné à durcir la résine, les cavités 11 se trouvent parfaitement colmatées.

Le cycle de métallisation chimique peut alors se dérouler sans risque que des impuretés pénètrent dans lesdites cavités à l'occasion des traitements chimiques prévus au début de ce cycle, avant la métallisation proprement dite.

La figure 1*d* montre le support une fois effectué le dépôt de métallisation. Aucun résidu ne subsiste entre le support isolant dont les cavités ont été colmatées par la résine photosensible et la couche de métallisation 13 formée par exemple de cuivre.

Le procédé de métallisation chimique est classique et il est inutile de le décrire en détail. On indiquera simplement que le cycle de métallisation comprend une étape de conditionnement du support, réalisée par des traitements qui dépendent de la matière du support et destinée à créer un relief d'accrochage, une étape d'implantation de germes, notamment de palladium, dans les cites

d'accrochage ainsi créés (opération appelée "catalyse"), et enfin le dépôt de métal conducteur proprement dit.

La suite du traitement est également classique: on procède à un dépôt électrolytique du métal conducteur pour renforcer le dépôt chimique, on dépose une réserve suivant le câblage à réaliser, on effectue un nouveau dépôt électrolytique jusqu'à l'épaisseur totale souhaitée, puis un dépôt électrolytique anti-corrosion (par exemple étain-plomb), on élimine la réserve et on grave le cuivre qui se trouvait sous la réserve. On peut enduite procéder à la mise en place des composants et à leur soudage.

La résine susceptible d'être solubilisée par un rayonnement utilisée pour l'enduction du support doit répondre à des caractéristiques précises.

— Elle doit posséder des propriétés électriques, convenant à l'utilisation dans un circuit imprimé, et en particulier une constante diélectrique élevée.

— Elle doit avoir une résistance thermique suffisante pour résister aux températures de soudage, d'environ 200—250°C.

— Elle doit avoir une excellente résistance aux agents chimiques pour ne pas être détruite par les produits présents dans les bains de traitement utilisés dans le cycle de métallisation.

Une telle résine comprend par exemple une résine phénol-formol dont le motif correspond à la formule

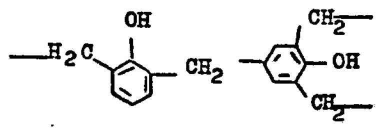

ou les résines crésol-formol de structure analogue, obtenues par réaction du formol avec le phénol (ou le crésol).

Cette résine est sensibilisée par un sensibilisateur diazoïque, par exemple une O-diazoquinone-sulfone de formule

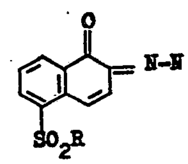

R étant un radical organique.

Ce sensibilisateur est à l'origine de la photosolubilisation conformément à la réaction

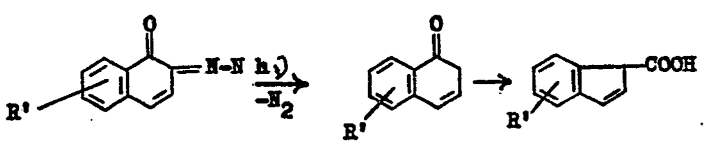

le produit final étant un acide indène-carboxylique.

Le rayonnement lumineux qu'on utilise dans ce cas est un rayonnement ultra-violet produit par une lampe à vapeur de mercure.

## Revendications

1. Procédé de réalisation de circuits imprimés à trous métallisés à partir de supports isolants en stratifié verre-résine synthétique, dans lequel on perce les trous à métalliser dans le support isolant, on effectue un dépôt de métal conducteur par métallisation chimique dans les trous et sur les deux faces, on réalise le câblage par gravure du métal conducteur sur les deux faces après avoir déposé une réserve, puis on positionne les composants électriques dans les trous métallisés et on soude la queue des composants dans les trous respectifs pour assurer les liaisons électriques, caractérisé par le fait que, immédiatement après le perçage des trous, on enduit le support (1) dont au moins la surface intérieure des trous (10) avec une résine photosensible (12) susceptible d'être solubilisée par un rayonnement, on expose le support enduit au dit rayonnement de façon, non sélective, on élimine la résine solubilisée par le rayonnement, puis on sèche le support.

2. Procédé selon la revendication 1, caractérisé par le fait que l'on effectue l'enduction sous vide.

3. Procédé selon l'une des revendications 1 et 2, caractérisé par le fait que la résine photosensible comprend une résine phénol-formol dont le motif répond à la formule

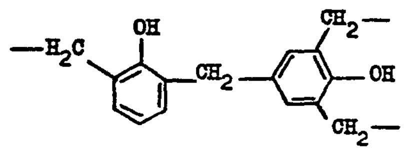

ou une résine crésol-formol de structure analogue, associée à un sensibilisateur diazoïque de formule

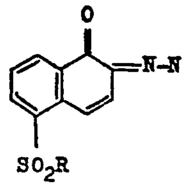

où R est un radical organique.

**Claims**

1. A process for producing printed circuit boards with metal-coated holes from insulated supports made of glass-synthetic resin laminate, in which the holes to be metal-coated are punched in the insulating support, a deposit of conductive metal is effected by chemical metal-coating in the holes and on both faces, the wiring is made by etching the conductive metal on both faces after having deposited a reserve, the then electrical components are positioned in the metal-coated holes and the tails of the components are soldered in the respective holes to provide for electrical connections, characterized by the fact that, immediately after the holes have been punched, the support (1) and at least the inner surface of the holes (10) are coated with a photosensitive resin (12) capable of being solubilized by radiation, the coated support is exposed to said radiation in non-selective manner, the resin thus solubilized by the radiation is removed and the support is dried.

2. A process as claimed in Claim 1, wherein the coating is effected in vacuo.

3. A process as claimed in one of Claims 1 and 2, wherein the photosensitive resin comprises a phenol-formal dehyde resin corresponding to the following formula:

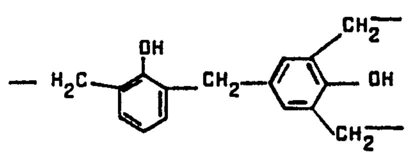

or a cresol formaldehyde resin of similar structure, associated with a diazo sensitizer of formula:

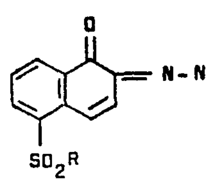

where R is an organic radical.

**Patentansprüche**

1. Verfahren zur Herstellung von gedruckten Schaltungen mit metallisierten Löchern, wobei man von einem Trägerkörper aus Isoliermaterial in Form eines aus Glas und Kunstharz zusammengesetzten Schichtsoffes ausgeht, den man mit den zu metallisierenden Löchern versieht, worauf man durch chemische Metallisierung in den Löchern und auf den beiden Außenflächen für einen Vorrat an leitendem Metall sorgt, auf den beiden Seiten nach dem Anlegen einer Reserve in einem Ätzvorgang die Verkabelung aus leitendem Metall vornimmt und danach die elektrischen Bauteile in den metallisierten Löchern positioniert und den Schaft der Bauteile zur Herstellung der elektrischen Verbindung in den betreffenden Löchern festlötet, dadurch gekennzeichnet, daß man unmittelbar nach dem Einbringen der Löcher (10) den Trägerkörper (1) und insbesondere die Wandungen der Löcher (10) mit einem lichtempfindlichen Harz (12) überzieht, das unter Einwirkung einer Strahlung löslich ist, und daß man den überzogenen Trägerkörper (10) in nicht selektiver Weise der Strahlung aussetzt und hierdurch das unter Strahleneinwirkung gelöste Harz entfernt, worauf man den Trägerkörper trocknet.

2. Verfahren nach Anspruch 1, dadurch gekennzeichnet, daß man das Überziehen des Trägerkörpers unter Vakuum vornimmt.

3. Verfahren nach Anspruch 1 oder 2, daß man als lichtempfindliches Harz ein Phenol-Formolharz nach der Formel

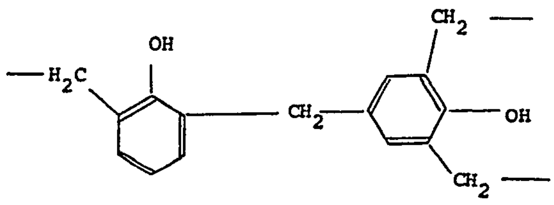

oder ein Kresol-Formolharz entsprechenden Aufbaues verwendet, das einem diazoischen Sensibilisator der Formel

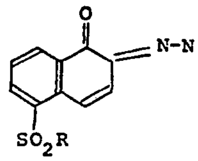

zugeordnet ist, wobei R ein organisches Radikal wiedergibt.

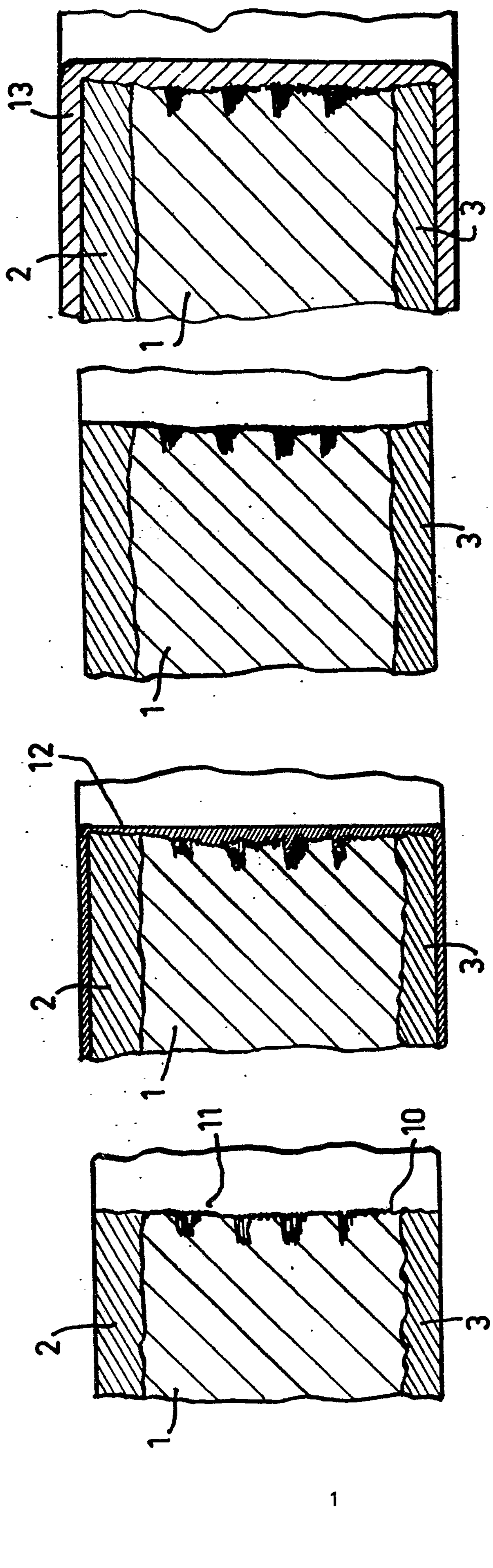


FIG.1d

FIG.1c

FIG.1b

FIG.1a